# EUROPÄISCHE PATENTSCHRIFT

(11) **EP 3 718 125 B1**
(45) Veröffentlichungstag und Bekanntmachung des Hinweises auf die Patenterteilung: **24.05.2023**
(21) Anmeldenummer: 18822141.0
(22) Anmeldetag: 21.11.2018
(51) Int. Cl.: H01H 47/00, H05B 6/06

(54) **HAUSHALTSGERÄT**
HOUSEHOLD APPLIANCE
APPAREIL MÉNAGER

(30) Priorität: 29.11.2017 ES 201731368
(43) Veröffentlichungstag der Anmeldung: 07.10.2020
(73) Patentinhaber: BSH Hausgeräte GmbH, 81739 München (DE)
(72) Erfinder: LLORENTE GIL, Sergio, 50009 Zaragoza (ES); MOYA LASHERAS, Eduardo, 50008 Zaragoza (ES); RAMIREZ LABOREO, Edgar Jorge, 50013 Zaragoza (ES); SAGÜES BLÁZQUIZ, Carlos, 50018 Zaragoza (ES)
(86) Internationale Anmeldenummer: PCT/IB2018/059161
(87) Internationale Veröffentlichungsnummer: WO 2019/106488

(56) Entgegenhaltungen:
- EP-A1- 2 892 071
- EP-A2- 0 711 099
- WO-A1-98/24106

## Beschreibung

Die Erfindung betrifft ein Haushaltsgerät nach dem Oberbegriff des Anspruchs 1 und ein Verfahren mit einem Haushaltsgerät nach dem Oberbegriff des Anspruchs 11.

Aus dem Stand der Technik sind Induktionsgargeräte bekannt, welche elektromechanische Schalteinheiten aufweisen, die als Relais ausgebildet und zwischen Wechselrichtern und zu betreibenden Induktoren angeordnet sind. Die Schaltperioden der elektromechanischen Schalteinheiten sind oft schwer kontrollierbar, da diese durch zahlreiche Störeinflüsse, beispielsweise durch eine Umgebungstemperatur und/oder eine Betriebsdauer der Schalteinheit, beeinflusst werden können. Dabei kann keine verlässliche Vorhersage über den Schaltzustand getroffen werden, wodurch Schaltzeiten verlängert werden sowie eine Schalteffizienz herabgesetzt wird.

Das Dokument EP 0 711 099 A2 offenbart ein Haushaltsgerät gemäß dem Oberbegriff des Anspruchs 1.

Die Aufgabe der Erfindung besteht insbesondere darin, ein gattungsgemäßes Haushaltsgerät mit verbesserten Eigenschaften hinsichtlich einer Schalteffizienz bereitzustellen. Die Aufgabe wird erfindungsgemäß durch die Merkmale der Ansprüche 1 und 11 gelöst, während vorteilhafte Ausgestaltungen und Weiterbildungen der Erfindung den Unteransprüchen entnommen werden können.

Die Erfindung geht aus von einem Haushaltsgerät insbesondere einer Gargerätevorrichtung und vorteilhaft einer Kochfeldvorrichtung, mit zumindest einer elektromechanischen Schalteinheit, welche zumindest eine Steuerspule aufweist, und zumindest einer Auswerteeinheit, welche dazu vorgesehen ist, zumindest einen Schaltzustand der elektromechanischen Schalteinheit zu ermitteln.

Es wird vorgeschlagen, dass die Auswerteeinheit dazu vorgesehen ist, den Schaltzustand mittels zumindest eines Induktivitätsparameters der Steuerspule zu ermitteln.

Durch die erfindungsgemäße Ausgestaltung kann insbesondere eine vorteilhafte Bestimmung des Schaltzustands einer Schalteinheit ermittelt werden, wobei insbesondere eine Messung von Kenngrößen des Arbeitskreises vermieden werden kann. Zudem kann erreicht werden, dass Schaltzeiten von elektrischen Komponenten, beispielsweise eines Wechselrichters, und/oder Schaltkreisen, insbesondere zu einem Ein- und/oder Ausschalten eines Kochfelds, insbesondere eines Induktionskochfelds, vorteilhaft reduziert werden. Hierdurch kann ein gesteigerter Bedienkomfort erzielt werden. Ferner kann die Betriebsdauer elektrischer und/oder elektronischer Bauteile erhöht werden. Vorteilhaft können Kosten aufgrund eines geringeren Wartungsaufwands durch eine gesteigerte Lebensdauer insbesondere elektronischer Bauteile sowie eines verminderten Energieverbrauchs aufgrund verkürzter Schaltzeiten reduziert werden.

Unter einer "Haushaltsgerätevorrichtung", insbesondere unter einer "Gargerätevorrichtung", vorteilhaft unter einer "Kochfeldvorrichtung" und besonders vorteilhaft unter einer "induktionskochfeldvorrichtung" soll insbesondere zumindest ein Teil, insbesondere eine Unterbaugruppe, eines Haushaltsgeräts, insbesondere eines Gargeräts, vorteilhaft eines Kochfelds und besonders vorteilhaft eines Induktionskochfelds, verstanden werden, wobei insbesondere zusätzlich auch Zubehöreinheiten für das Haushaltsgerät umfasst sein können, wie beispielsweise eine Sensoreinheit insbesondere zur externen Messung einer Temperatur eines Gargeschirrs und/oder eines Garguts. Insbesondere kann die Haushaltsgerätevorrichtung auch das gesamte Haushaltsgerät, insbesondere das gesamte Gargerät, vorzugsweise das gesamte Kochfeld und besonders bevorzugt das gesamte Induktionskochfeld, umfassen. Alternativ kann das Haushaltsgerät als ein Haushaltskältegerät, als eine Geschirrspülmaschine, als ein Wäschebehandlungsgerät, insbesondere eine Waschmaschine und/oder ein Wäschetrockner, und/oder als ein weiteres, einem Fachmann als sinnvoll erscheinendes Gerät ausgebildet sein.

Unter einer "elektromechanischen Schalteinheit" soll insbesondere eine Schalteinheit verstanden werden, welche zumindest ein Schaltelement aufweist und welche zumindest eine mechanische Komponente aufweist, welche durch ein elektrisches Signal, einen elektrischen Strom, eine elektrische Spannung oder eine andere, auf einer elektromagnetischen Ursache beruhende Größe beeinflusst, insbesondere bewegt, wird und insbesondere zwischen zwei Kontakten des Schaltelements eine elektrisch leitende Verbindung herstellt und/oder trennt. Unter einem "Schaltelement" soll insbesondere ein Element verstanden werden, das dazu vorgesehen ist, zwischen zwei Kontakten des Schaltelements eine elektrisch leitende Verbindung herzustellen und/oder zu trennen. Vorzugsweise weist das Schaltelement zumindest einen Steuerkontakt auf, über den es geschaltet werden kann. Insbesondere ist das Schaltelement als Halbleiterschaltelement, insbesondere als Transistor, vorteilhaft als Bipolartransistor mit vorzugsweise isolierter Gate-Elektrode (IGBT), ausgebildet. Alternativ ist das Schaltelement als mechanisches und/oder elektromechanisches Schaltelement, insbesondere als ein Relais, ausgebildet.

Unter einer "Steuerspule" soll hier insbesondere eine Spule verstanden werden, welche Teil eines elektrischen Steuerstromkreises ist und durch welche ein elektrischer Strom fließen kann. Insbesondere ist die Steuerspule Teil einer elektromechanischen Schalteinheit. Insbesondere entsteht bei einem Aktivieren der Steuerspule, indem eine elektrische Spannung an die Steuerspule angelegt wird, an der Steuerspule ein magnetisches Feld, welches insbesondere einen Anker, welcher vorzugsweise als ein ferromagnetischer Stab ausgebildet ist, anzieht. Durch die Bewegung des Ankers kann ein Schaltelement, welches Teil eines Arbeitsstromkreises sein kann, geöffnet oder geschlossen werden. Insbesondere kehren der Anker, und damit auch das Schaltelement, nach einem Entfernen der angelegten elektrischen Spannung in ihre Ausgangsposition zurück. Die Steuerspule ist insbesondere durch einen elektrischen Steuerstromkreis aktivierbar. Insbesondere kann die Steuerspule den vom Steuerstromkreis elektrisch getrennten, insbesondere galvanisch getrennten, Arbeitsstromkreis, insbesondere das zum Arbeitsstromkreis gehörende Schaltelement, beeinflussen und insbesondere aus-, ein- und/oder umschalten. Insbesondere kann durch Schließen des Schaltelements einem elektrischen Verbraucher im Arbeitsstromkreis eine elektrische Leistung zugeführt werden. In diesem Zusammenhang soll unter einem "Steuerstromkreis" insbesondere ein elektrischer Stromkreis zu einer Versorgung einer elektromechanischen Schalteinheit, insbesondere der Steuerspule, mit einer elektrischen Energie und zum Steuern, insbesondere Schalten, von elektrischen Strömen in einem vom Steuerstromkreis elektrisch, insbesondere galvanisch, getrennten Arbeitsstromkreis verstanden werden. Unter "galvanisch getrennten Stromkreisen" soll insbesondere verstanden werden, dass jeweilige elektrische Potentiale der Stromkreise voneinander getrennt sind und die Stromkreise untereinander potentialfrei sind, wobei eine gegenseitige Einwirkung der Stromkreise stattfinden kann, beispielsweise durch einen Signalaustausch zwischen den Stromkreisen, wobei insbesondere eine Energie oder ein Signal zwischen den Stromkreisen übertragen werden kann. Unter einem "Arbeitsstromkreis" soll hier insbesondere ein Stromkreis verstanden werden, welcher vom Steuerstromkreis elektrisch und insbesondere galvanisch getrennt ist, insbesondere eine Schalteinheit aufweist und vorzugsweise dazu vorgesehen ist, einen elektrischen Verbraucher oder eine Nutzlast mit einer elektrischen Energie zu versorgen.

Unter einer "Auswerteeinheit" soll insbesondere eine Einheit verstanden werden, welche dazu vorgesehen ist, zumindest ein Eingangssignal zu empfangen, das Eingangssignal zu verarbeiten und ein Ausgangssignal zu erzeugen, welches zu einer Informationsübertragung, zu einer Steuerung und/oder einer Regelung geeignet ist. Vorteilhaft weist die Auswerteeinheit zumindest eine Prozessoreinheit, eine Speichereinheit, ein Ein- und Ausgabemittel, weitere elektrische und/oder elektronische Bauteile, ein Betriebsprogramm, Regelroutinen, Algorithmen, Steuerroutinen und/oder Berechnungsroutinen auf. Vorzugsweise sind die Bauteile der Auswerteeinheit auf einer gemeinsamen Platine angeordnet und/oder vorteilhaft in einem gemeinsamen Gehäuse angeordnet. Insbesondere kann die Auswerteeinheit das Eingangssignal abspeichern, mit dem Eingangssignal Rechenoperationen durchführen, das Eingangssignal als Parameter einem Algorithmus zur Verfügung stellen und anschließend ein Ausgangssignal erzeugen sowie funktionale Zusammenhänge zwischen Eingangsgrößen ermitteln und/oder herstellen. Vorzugsweise ist die Auswerteeinheit programmierbar ausgebildet, sodass insbesondere weitere Algorithmen der Auswerteeinheit zur Verfügung gestellt werden können. Insbesondere kann die Auswerteeinheit eine Steuereinheit umfassen. Unter einer "Steuereinheit" soll insbesondere eine elektronische Einheit verstanden werden, die vorzugsweise in einer Auswerteeinheit einer Haushaltsgerätevorrichtung zumindest teilweise integriert ist und die vorzugsweise dazu vorgesehen ist, zumindest eine Schalteinheit zu steuern und/oder zu regeln. Vorzugsweise umfasst die Steuereinheit eine Recheneinheit und insbesondere zusätzlich zur Recheneinheit eine Speichereinheit mit einem darin gespeicherten Steuer- und/oder Regelprogramm, das dazu vorgesehen ist, von der Recheneinheit ausgeführt zu werden.

Unter einem "Schaltzustand" einer Schalteinheit soll insbesondere ein Zustand verstanden werden, in dem die Schalteinheit entweder offen oder geschlossen ist. Insbesondere kann im geschlossenen Zustand der Schalteinheit ein elektrischer Stromfluss in einem elektrischen Stromkreis möglich sein und insbesondere im offenen Zustand eine Unterbrechung des elektrischen Stromflusses im elektrischen Stromkreis erfolgen.

Unter einem "Induktivitätsparameter" soll hier insbesondere eine Induktivität der Spule, insbesondere der Steuerspule, und/oder insbesondere ein verketteter magnetischer Fluss verstanden werden.

Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Des Weiteren wird vorgeschlagen, dass die Haushaltsgerätevorrichtung zumindest eine Sensoreinheit aufweist, welche zu einer Messung eines Spulenstroms durch die und/oder in der Steuerspule vorgesehen ist. Unter einer "Sensoreinheit" soll in diesem Zusammenhang insbesondere eine Einheit verstanden werden, die dazu vorgesehen ist, zumindest eine Kenngröße und/oder eine physikalische Eigenschaft mittels eines Sensorelements aufzunehmen, wobei die Aufnahme aktiv, wie insbesondere durch Erzeugen und Aussenden eines elektrischen Messsignals, und/oder passiv, wie insbesondere durch eine Erfassung von Eigenschaftsänderungen eines Sensorbauteils, stattfinden kann. Es sind verschiedene, dem Fachmann als sinnvoll erscheinende Sensoreinheiten denkbar. Unter einem "Sensorelement" soll insbesondere ein Element verstanden werden, welches dazu vorgesehen ist, wenigstens eine Sensorkenngröße zu detektieren und eine die Sensorkenngröße kennzeichnende Größe auszugeben, wobei es sich bei der Sensorkenngröße vorteilhaft um eine physikalische, insbesondere mit einem elektrischen Strom korrelierte Größe handelt. Dadurch kann der Spulenstrom, welcher durch die Spule fließt, erfasst werden und insbesondere zu einer Weiterverarbeitung an eine weitere Einheit übermittelt werden. Insbesondere kann die Sensoreinheit zumindest teilweise einstückig mit der Auswerteeinheit ausgebildet sein. Darunter, dass zwei Einheiten "zumindest teilweise einstückig" ausgebildet sind, soll insbesondere verstanden werden, dass die Einheiten zumindest ein, insbesondere zumindest zwei, vorteilhaft zumindest drei gemeinsame Elemente aufweisen, die Bestandteil, insbesondere funktionell wichtiger Bestandteil, beider Einheiten sind.

In einer weiteren Ausgestaltung wird vorgeschlagen, dass die Sensoreinheit zumindest einen Messwiderstand, insbesondere einen Shunt-Widerstand, aufweist. Ein am Messwiderstand, insbesondere am Shunt-Widerstand, entstehender, zum Spulenstrom proportionaler Spannungsabfall ist detektierbar und ist dazu vorgesehen, diesen als Sensorgröße zur Weiterverarbeitung zur Verfügung zu stellen. Insbesondere ist der Messwiderstand zu einer Messung eines Gleichstroms vorgesehen. Vorzugsweise ist der Messwiderstand als ein niederohmiger Widerstand ausgebildet und weist insbesondere einen ohmschen Widerstand von höchstens 10 Ohm, vorzugsweise von maximal 0,1 Ohm und besonders vorteilhaft von höchstens 10 Milliohm auf. Ein Widerstandswert des Messwiderstands könnte in einem Bereich unter einem Milliohm liegen. Alternativ zu einer Ausgestaltung des Messwiderstands als Shunt-Widerstand könnte der Messwiderstand einen anderen zu einer Strommessung geeigneten Widerstand und/oder einen Sensor, beispielsweise einen Hall-Effekt-Sensor oder einen Magnetfeldsensor, aufweisen. Hierdurch kann eine vorteilhaft einfache und kostengünstige Möglichkeit zu einer Spulenstrommessung bereitgestellt werden.

Zudem wird vorgeschlagen, dass die Haushaltsgerätevorrichtung zumindest einen Steuerstromkreis zur Ansteuerung der Steuerspule aufweist, in welchem der Messwiderstand angeordnet ist. Insbesondere ist der Steuerstromkreis mit einem Gleichstrom vorteilhaft in einem niedrigen Spannungsbereich betreibbar. Hierdurch kann insbesondere ein Energieverbrauch reduziert werden. Insbesondere ist der Steuerstromkreis dazu vorgesehen, die Steuerspule mit elektrischer Energie zu versorgen und dadurch insbesondere den Schaltzustand der elektromagnetischen Schalteinheit zu beeinflussen. Es könnte dadurch beispielsweise ein externer Stromkreis, insbesondere der Arbeitsstromkreis, geschlossen werden, welcher ein Induktionskochfeld mit der elektrischen Energie versorgt. Durch eine Anordnung des Messwiderstands im Steuerkreis kann insbesondere eine präzise Bestimmung des Messwiderstands erfolgen. Ferner können durch die Anordnung des Messwiderstands im Steuerkreis eine Kostenreduktion und ein verringerter Energieverbrauch erreicht werden.

Ferner wird vorgeschlagen, dass die Auswerteeinheit dazu vorgesehen ist, den Induktivitätsparameter aus einem von der Sensoreinheit bereitgestellten Signal zu bestimmen. Insbesondere kann das Signal mit dem Spulenstrom und/oder insbesondere mit einer Ableitung des Spulenstroms nach der Zeit und/oder einer anderen, mit der Induktivität der Spule zusammenhängenden Größe korreliert sein. Insbesondere kann eine Induktivität der Spule indirekt gemessen werden. Insbesondere kann die Auswerteeinheit zur Ermittlung des Induktivitätsparameters einen Kalman-Filter-Ansatz oder alternativ einen reset-observer-Ansatz benutzen, wobei ein Zustand eines Systems mit Hilfe von Messdaten geschätzt wird. Dabei erfolgt eine Schätzung von Parametern eines dynamischen Systems bei einer sich wiederholenden Messung, wobei die Parameter nicht direkt messbar sind, jedoch durch mathematische Gleichungen, beispielsweise durch Bewegungsgleichungen und/oder mathematisch formulierte physikalische Zusammenhänge als ein mathematisches Modell beschrieben werden können. Dadurch kann der Schaltzustand der elektromechanischen Schalteinheit einfach, kostengünstig und insbesondere indirekt ohne einen Einsatz von zusätzlichen Messsensoren bestimmt werden.

In einer weiteren Ausgestaltung wird vorgeschlagen, dass die Auswerteeinheit dazu vorgesehen ist, den Induktivitätsparameter aus dem Spulenstrom bei zumindest zeitweise konstanter, an der Steuerspule angelegter Spulenspannung zu bestimmen. Unter einer "konstanten Spulenspannung" soll hier insbesondere eine konstante mittlere Gleichspannung verstanden werden. Insbesondere kann die an der Steuerspule angelegte Spulenspannung eine pulsdauermodulierte Rechteckgleichspannung sein, wobei die konstante mittlere Gleichspannung U_ sich als U_=Uo*(t/T) bestimmen lässt, wobei Uo die in einer Einschaltphase pulsdauermodulierte Rechteckgleichspannung, t eine Pulsdauer der pulsdauermodulierten Rechteckgleichspannung und T eine Periodendauer der pulsdauermodulierten Rechteckgleichspannung sowie t/T ein Tastverhältnis ist. Dadurch kann insbesondere eine Gleichspannungsquelle verwendet werden, welche eine konstante Gleichspannungsversorgung, insbesondere eine Niedervoltgleichspannungsversorgung, bereitstellt und somit einfach zu realisieren und kostengünstig ist. Insbesondere können Standardkomponenten für einen Aufbau des Steuerstromkreises verwendet werden. Hierdurch können Herstellungskosten reduziert werden. Ferner ist insbesondere eine Induktivität der Steuerspule aufgrund einer einfach zu realisierenden Spulenstrommessung möglich.

Eine Bestimmung des Induktivitätsparameters könnte mittels zumindest einer auf der Speichereinheit der Auswerteeinheit abgelegten Vergleichswertetabelle erfolgen, welche insbesondere diskrete Spulenstromwerte und Induktivitätsparameterwerte der Steuerspule umfasst, wobei zu jedem Spulenstromwert ein dazugehöriger Induktivitätsparameterwert existiert. Durch einen Vergleich eines gemessenen Spulenstromwerts mit den Werten in der Vergleichswertetabelle ist, insbesondere mittels einer Interpolation, ein entsprechender Induktivitätsparameterwert bestimmbar. Dabei erfordert die oben erwähnte Bestimmung mittels Vergleichswertetabellen einen relativ großen Speicherbedarf und ist mit Ungenauigkeiten behaftet, weshalb auf andere, präzisere Möglichkeiten einer Induktivitätsparameterbestimmung zurückgegriffen wird.

Eine vorteilhafte Bestimmung des Induktivitätsparameters kann erreicht werden, wenn die Auswerteeinheit dazu vorgesehen ist, den Induktivitätsparameter als Funktion des Spulenstroms bei zumindest zeitweise konstanter, an der Steuerspule angelegterSpulenspannung zu bestimmen. Dadurch kann die Induktivität der Spule direkt bestimmt werden, wobei Werte der Spulenspannung und des durch die Spule fließenden Stroms benötigt werden. Insbesondere kann dazu ein mathematischer Zusammenhang verwendet werden, laut welchem eine angelegte elektrische Spannung U_{q} eine Summe einer Spannung, welche am internen elektrischen Widerstand R_{q} abfällt, und einer selbstinduzierten Spannung: U_{q}=l*R_{q}+d(L* l)/dt ist, wobei L als Induktivität der Spule und das Produkt L*l als verketteter Fluss Ψ bezeichnet wird, wobei der verkettete Fluss Ψ für eine Spule als Produkt aus einer Anzahl der Windungen N der Spule und des durch die Spule hindurchgreifenden magnetischen Flusses Φ, Ψ=n*Φ bezeichnet wird.

Darüber hinaus wird vorgeschlagen, dass die Auswerteeinheit dazu vorgesehen ist, den Schaltzustand aus dem Induktivitätsparameter anhand zumindest eines Modells zu bestimmen. Insbesondere kann dadurch auf weitere Sensoren verzichtet werden, um beispielsweise einen geschlossenen oder einen offenen Schaltzustand eines Schaltelements direkt zu ermitteln. Es ist eine Bestimmung des Schaltzustandes mittels zumindest einer auf der Speichereinheit der Auswerteeinheit abgelegten, insbesondere empirisch bestimmten, Vergleichswertetabelle denkbar, welche insbesondere diskrete Induktivitätsparameterwerte und Schaltzustandswerte, beispielsweise eine Position eines Schalters, umfasst, wobei zu jedem Induktivitätsparameterwert ein dazugehöriger Schaltzustandswert existiert. Durch einen Vergleich eines gemessenen Induktivitätsparameterwerts mit den Werten in der Vergleichswertetabelle ist, insbesondere mittels einer Interpolation, ein entsprechender Schaltzustand bestimmbar. Vorzugsweise werden aufgrund präziserer Ergebnisse und einer erhöhten Flexibilität andere Methoden zur Bestimmung eingesetzt.

Eine besonders hohe Flexibilität bei einer Bestimmung des Schaltzustands kann erreicht werden, wenn die Auswerteeinheit dazu vorgesehen ist, den Schaltzustand aus dem Induktivitätsparameter anhand zumindest eines theoretischen Modells zu bestimmen. Insbesondere könnte der Schaltzustand bei einem funktionellen Zusammenhang zwischen dem Induktionsparameter und dem Schaltzustand der elektromechanischen Schalteinheit, beispielsweise in Form von L=f(x), bei einer Kenntnis einer inversen Funktion x=f⁻¹ ermittelt werden, wobei L die Induktivität der Steuerspule und x ein Schaltzustand, insbesondere eine Position beispielsweise eines Schalters der elektromechanischen Schalteinheit ist. Insbesondere kann das theoretische Modell an eine beliebige Schalteinheit angepasst werden, sodass dadurch eine Verbesserung und Vereinfachung der Schaltzustandsbestimmung erzielt werden kann. Das theoretische Modell kann in Form eines Algorithmus vorzugsweise auf einer Speichereinheit des Auswerteeinheit gespeichert werden.

Umfasst das Modell ein MEC-Modell (magnetic equivalent circuit), können insbesondere Vorteile hinsichtlich eines geringeren Speicherbedarfs, hoher Genauigkeit und Effizienz bei der Bestimmung des Schaltzustands erreicht werden. Das analytische MEC-Modell kann in Form eines Algorithmus vorzugsweise auf einer Speichereinheit der Auswerteeinheit gespeichert werden. Vorzugsweise kann der Algorithmus in Echtzeit ausgeführt werden. Insbesondere kann eine physikalische Beziehung nach hopkinsonschem Gesetz N*l=Φ*Rₘ ausgewertet werden, in dem das Produkt N*l eine magneto-motorische Kraft MMK darstellt, welche auch äquivalent zu einer elektromotorischen Kraft EMK=l*R als MMK=Φ*Rₘ formuliert werden kann, wobei N die Anzahl der Windungen einer Steuerspule, I ein elektrischer Strom in der Steuerspule, Φ ein magnetischer Fluss und Rₘ ein magnetischer Widerstand ist. Insbesondere kann das MEC-Modell weitere magnetische Einflussgrößen berücksichtigen, wie beispielsweise Hystereseeffekte, Wirbelströme und/oder Sättigungseffekte. Insbesondere kann eine Position eines Schalters zwischen zwei Kontakten der elektromechanischen Schalteinheit mittels des MEC-Modells bestimmt werden.

Umfasst das Modell ein FEA-Modell (finite element analysis), können insbesondere Vorteile hinsichtlich einer Schnelligkeit bei der Bestimmung des Schaltzustands erreicht werden. Beispielsweise können Maxwell-Gleichungen und Bewegungsgleichungen zu einer numerischen Bestimmung des Schaltzustands mittels des FEA-Modells eingesetzt werden. Insbesondere kann eine numerische Bestimmung eines elektro-magnetischen Felds der Spule und insbesondere der elektromechanischen Schalteinheit und somit des Schaltzustands erfolgen. Das numerische FEA-Modell kann in Form eines Algorithmus vorzugsweise auf einer Speichereinheit der Auswerteeinheit gespeichert werden. Vorzugsweise kann der Algorithmus in Echtzeit ausgeführt werden. Insbesondere erfordert das FEA-Modell Berechnungen im Vorfeld, welche anschließend in der Speichereinheit der Auswerteeinheit abgelegt werden und dem FEA-Modell bei der Bestimmung des Schaltzustands der elektromechanischen Schalteinheit zur Verfügung stehen. Insbesondere kann eine Position eines Schalters zwischen zwei Kontakten der elektromechanischen Schalteinheit mittels des FEA-Modells bestimmt werden.

Eine vorteilhaft hohe Schalteffizienz kann durch ein Haushaltsgerät, insbesondere ein Gargerät, erzielt werden, welches eine Haushaltsgerätevorrichtung aufweist.

Ferner wird ein Verfahren mit einem Haushaltsgerät, insbesondere mit einer Gargerätevorrichtung, vorzugsweise mit einer Induktionskochvorrichtung, mit zumindest einer elektromechanischen Schalteinheit, welche zumindest eine Steuerspule aufweist, vorgeschlagen, wobei zumindest ein Schaltzustand der elektromechanischen Schalteinheit ermittelt wird, wobei der Schaltzustand mittels zumindest eines Induktivitätsparameters der Steuerspule ermittelt wird. Hierdurch können eine vorteilhaft hohe Schalteffizienz und insbesondere eine kürzere Schaltperiode elektrischer Verbraucher, beispielsweise von Induktionskochzonen eines Induktionskochfelds, erzielt werden.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Kochfeld mit einer Haushaltsgerätevorrichtung in einer schematischen Draufsicht,
- Fig. 2: ein Schaltdiagramm eines Steuerstromkreises und eines Arbeitsstromkreises mit einer elektromechanischen Schalteinheit,
- Fig. 3: eine Diagrammdarstellung eines Spannungsverlaufs, eines resultierenden Stromverlaufs in einer Steuerspule und einer Induktivität der Steuerspule,
- Fig. 4: ein Diagramm einer Simulation eines Stromverlaufs und eines mit dem Stromverlauf korrelierten Schaltzustands und
- Fig. 5: ein Ablaufdiagramm eines Verfahrens mit der Haushaltsgerätevorrichtung zu einer Ermittlung eines Schaltzustands der elektromechanischen Schalteinheit.

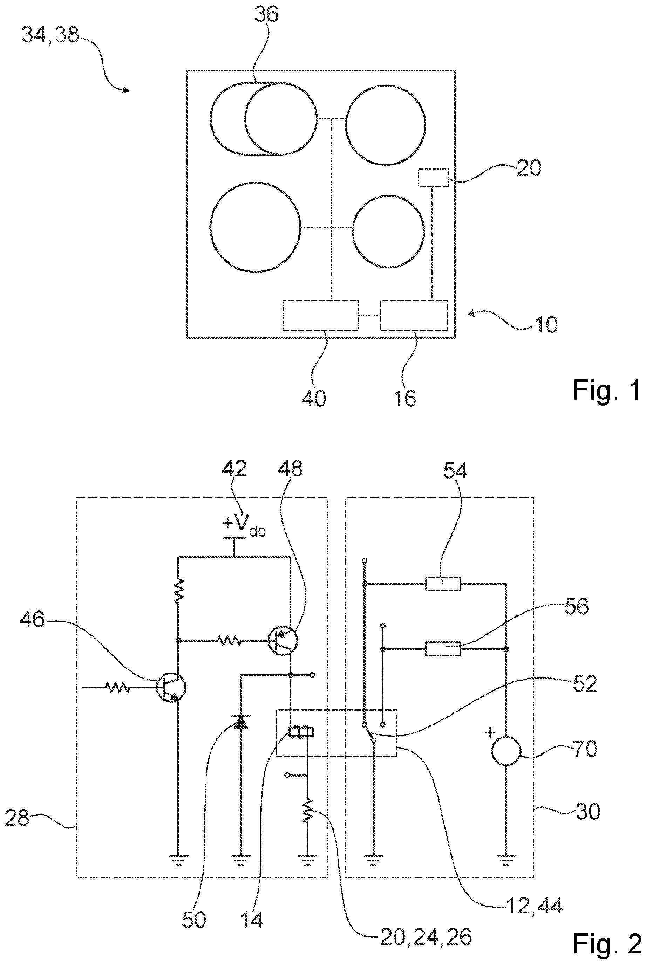

Figur 1 zeigt ein als Kochfeld 38 ausgebildetes Haushaltsgerät 34. Das Haushaltsgerät 34 weist vier Kochzonen 36 auf. Das Haushaltsgerät 34 weist eine Haushaltsgerätevorrichtung 10 auf. Das Kochfeld 38 kann als Induktionskochfeld ausgebildet sein. Alternativ könnte ein Haushaltsgerät 34 auch als Gargerät, beispielsweise als ein Backofen, wie beispielsweise ein Induktionsbackofen, und/oder als ein Kühlschrank und/oder als ein Geschirrspüler ausgebildet sein.

Die Haushaltsgerätevorrichtung 10 weist eine elektromechanische Schalteinheit 12 auf. Die elektromechanische Schalteinheit 12 weist eine Steuerspule 14 auf.

Die Haushaltsgerätevorrichtung 10 weist eine Auswerteeinheit 16 auf. Die Auswerteeinheit 16 ist dazu vorgesehen, den Schaltzustand mittels zumindest eines Induktivitätsparameters 18 der Steuerspule 14 zu ermitteln.

Die Haushaltsgerätevorrichtung 10 weist eine Sensoreinheit 20 auf. Die Sensoreinheit 20 ist zu einer Messung eines Spulenstroms 22 in der Steuerspule 14 vorgesehen. Die Sensoreinheit 20 weist einen Messwiderstand 24 auf. Der Messwiderstand 24 ist als ein Shunt-Widerstand 26 ausgebildet. Der Shunt-Widerstand 26 ist vorzugsweise als ein niederohmiger Widerstand ausgebildet. Alternativ kann die Sensoreinheit 20 auch Hall-Effekt-Sensoren und/oder Magnetfeldsensoren aufweisen.

Die Haushaltsgerätevorrichtung 10 weist eine Steuereinheit 40 auf. Insbesondere können die Steuereinheit 40 und die Auswerteeinheit 16 zumindest teilweise einstückig ausgebildet sein. Die Steuereinheit 40 ist dazu vorgesehen, eine elektrische Leistung, welche den Kochzonen 36 zugeführt werden soll, zu kontrollieren und zu steuern.

Figur 2 zeigt ein Schaltdiagramm eines Steuerstromkreises 28 und eines Arbeitsstromkreises 30 mit der elektromechanischen Schalteinheit 12. Der Steuerstromkreis 28 und der Arbeitsstromkreis 30 sind voneinander galvanisch getrennt.

Der Steuerstromkreis 28 ist dazu vorgesehen, die Steuerspule 14 anzusteuern. Der Steuerstromkreis 28 umfasst eine elektrische Versorgungsquelle 42. Die Versorgungsquelle 42 ist als eine Gleichspannungsquelle ausgebildet. Die Gleichspannungsquelle stellt eine Versorgungsspannung der Steuerspule 14 zur Verfügung.

Der Steuerstromkreis 28 umfasst die Steuerspule 14. Die Steuerspule 14 ist Teil der elektromechanischen Schalteinheit 12. Zu einer Messung des Spulenstroms 22 in der Steuerspule 14 ist der Shunt-Widerstand 26 in Reihe zur Steuerspule 14 geschaltet. Der Shunt-Widerstand 26 ist dazu vorgesehen, den Spulenstrom 22 zu messen und an die Auswerteeinheit 16 zu übermitteln. Der Steuerstromkreis 28 umfasst zwei Transistoren 46, 48. Die Transistoren 46, 48 sind dazu vorgesehen, den Spulenstrom 22 zu kontrollieren. Der Steuerstromkreis 28 umfasst weitere Widerstände, welche dazu vorgesehen sind, in Verbindung mit Transistoren 46, 48 den Spulenstrom 22 zu steuern.

Der Steuerstromkreis 28 umfasst eine Freilaufdiode 50. Die Freilaufdiode 50 ist parallel zur Steuerspule 14 geschaltet. Die Freilaufdiode 50 ist dazu vorgesehen, nach einem Abschalten der elektrischen Energieversorgung eine Dissipation einer Energie eines Magnetfelds, welches in der Steuerspule 14 gespeichert ist, zu ermöglichen und somit Komponenten des Steuerstromkreises 28 vor einer Überspannung aufgrund einer Selbstinduktion der Steuerspule 14 zu schützen.

Die elektromechanische Schalteinheit 12 ist als ein single pole double throw (SPOT) Relais 44 ausgebildet. Das Relais 44 umfasst neben der Steuerspule 14 ein Schaltelement 52. Das Schaltelement 52 ist Teil eines Arbeitsstromkreises 30. Das Schaltelement 52 stellt in einem geschlossenen Zustand einen Stromkreislauf her. Der Arbeitsstromkreis 30 umfasst zwei elektrische Verbraucher 54, 56. Abhängig von einer Position 62 des Schaltelements 52 sind die elektrischen Verbraucher 54, 56 jeweils einzeln durch eine weitere elektrische Versorgungsquelle 70 mit einer elektrischen Energie versorgt. Es sind jedoch andere Steuerstromkreisschaltungen sowie Arbeitskreisstromschaltungen denkbar, welche an eine jeweilige Ausgestaltung der Haushaltsgerätevorrichtung 10 angepasst sind, wobei sie weitere elektronische Komponenten umfassen, und welche zumindest eine elektromechanische Schalteinheit 12 sowie zumindest eine Steuerspule 14 aufweisen.

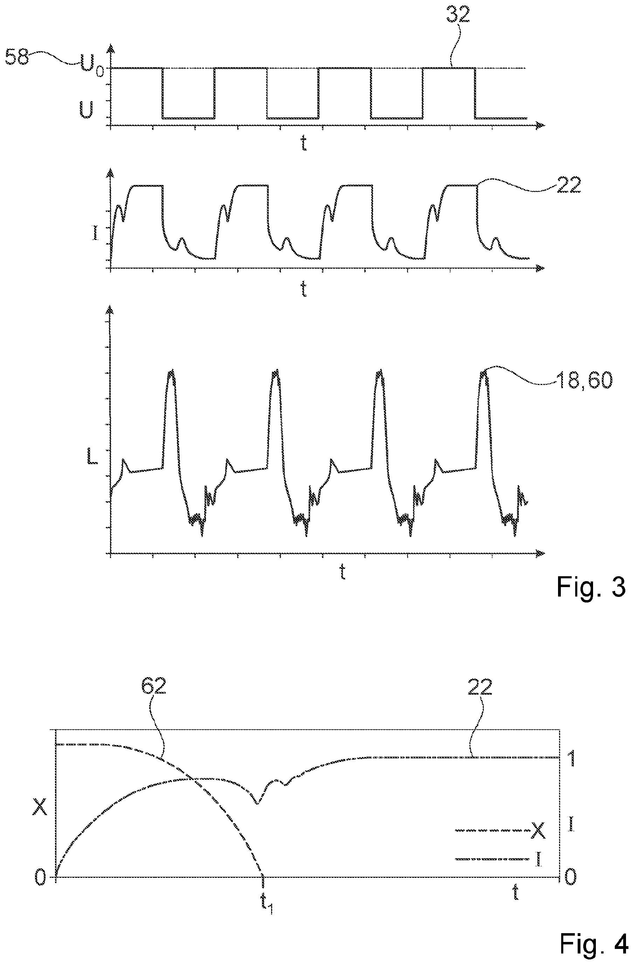

Die Auswerteeinheit 16 ist dazu vorgesehen, mit Hilfe des vom Shunt-Widerstand 26 gemessenen Spulenstroms 22 einen Induktivitätsparameter 18 zu bestimmen. Der Induktivitätsparameter 18 ist eine Induktivität 60 der Steuerspule 14 (vgl. Fig. 3). Alternativ kann ein verketteter magnetischer Fluss als Induktivitätsparameter 18 durch die Auswerteeinheit 16 bestimmbar sein.

Figur 3, oben zeigt eine Diagrammdarstellung eines zeitlichen Verlaufs einer an der Steuerspule 14 angelegten Spulenspannung 32. Die angelegte Spulenspannung 32 ist eine Gleichspannung. Die Spulenspannung 32 weist einen rechteckförmigen Verlauf auf. Die Spulenspannung 32 versorgt die Steuerspule 14 mit einer konstanten mittleren Spulenspannung 32 U_. Die konstante mittlere Spulenspannung 32 U_ kann durch eine Gleichung U_=Uo*(t/T) bestimmt werden, wobei Uo einen Spitzenwert 58 der Spulenspannung 32, t eine Pulsdauer der Spulenspannung 32 und T eine Periodendauer der Spulenspannung 32 darstellt. Ein Tastverhältnis t/T der Spulenspannung 32 beträgt 1/2. Der Spitzenwert 58 der Spulenspannung 32 hat in dem gesamten, in der Diagrammdarstellung gezeigten zeitlichen Verlauf einen konstanten Wert.

Figur 3, Mitte zeigt einen durch die Steuerspule 14 fließenden Spulenstrom 22 mit der an der Steuerspule 14 angelegten, in Figur 3 oben dargestellten Spulenspannung 32. Der Spulenstrom 22 ist mittels der Sensoreinheit 20, insbesondere mittels des Shunt-Widerstands 26, messbar.

Die Auswerteeinheit 16 ermittelt die Induktivität 60 der Steuerspule 14 als Funktion des durch den Shunt-Widerstand 26, in Figur 3 Mitte dargestellten, gemessenen Spulenstroms 22 (vgl. Fig. 3, unten). Zur Ermittlung der Induktivität 60 nutzt die Auswerteeinheit 16 einen Kalman-Filter-Ansatz (vgl. Fig. 3, unten). Alternativ nutzt die Auswerteeinheit 16 einen reset-observer-Ansatz.

Die Auswerteeinheit 16 bestimmt den Schaltzustand der elektromechanischen Schalteinheit 12 mittels der Induktivität 60 der Steuerspule 14. Die Auswerteeinheit 16 nutzt einen in einer Speichereinheit der Auswerteeinheit 16 gespeicherten Algorithmus zur Bestimmung des Schaltzustands. Zur Bestimmung des Schaltzustands benötigt der Algorithmus Werte der Spulenspannung 32 und des durch die Sensoreinheit 20 gemessenen Spulenstroms 22.

Der Algorithmus stellt eine Beziehung zwischen der Induktivität 60 der Steuerspule 14 und dem Schaltzustand der elektromechanischen Schalteinheit 12 her. Beispielsweise kann der Schaltzustand der elektromechanischen Schalteinheit 12 als Position 62 eines Schaltelements 52 der elektromechanischen Schalteinheit 12 dargestellt werden.

Der Algorithmus basiert auf einem MEC-Modell (magnetic equivalent circuit). Alternativ oder zusätzlich kann der Algorithmus auf einem FEA-Modell basieren. Dem Algorithmus liegt eine Annahme zugrunde, welche eine funktionale Beziehung zwischen der Induktivität 60 der Steuerspule 14 und dem Schaltzustand der elektromechanischen Schalteinheit 12 herstellt: L=f(x), wobei L die Induktivität 60 der Steuerspule 14 und x der Schaltzustand ist. Somit kann eine inverse Funktion von f bekannt sein: x=f⁻¹(L).

Figur 4 zeigt ein Diagramm einer Simulation eines Spulenstromverlaufs und der mit dem Spulenstrom 22 korrelierten, durch den Algorithmus ermittelten Position 62 eines elektromechanischen Schalters am Beispiel eines Magnetventils. Die Abszisse ist als eine Zeitachse dargestellt. Eine linke Ordinatenachse zeigt die Position 62 des elektromechanischen Schalters. Eine rechte, auf eins normierte Ordinatenachse zeigt einen Spulenstromwert. Bei einem Anlegen der Spulenspannung 32 steigt der Spulenstrom 22, bis ein Sättigungswert erreicht ist. Die Position 62 des elektromechanischen Schalters ist mit dem Spulenstrom 22 korreliert. Die Position 62 des elektromechanischen Schalters ändert sich nicht linear und erreicht eine Endposition bei x=0 an einem Zeitpunkt t₁.

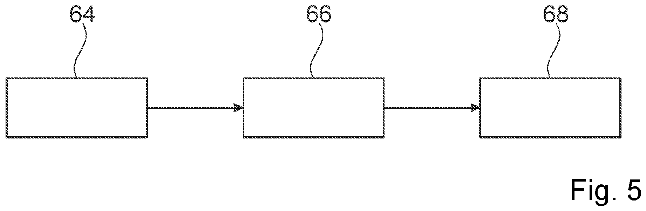

Figur 5 zeigt ein Ablaufdiagramm eines Verfahrens zu einer Ermittlung des Schaltzustands der elektromechanischen Schalteinheit 12. Das Verfahren umfasst drei Schritte. In einem ersten Verfahrensschritt 64 wird der Spulenstrom 22 gemessen. Der Spulenstrom 22 wird mittels der Sensoreinheit 20, insbesondere mittels des Shunt-Widerstands 26, gemessen. Die Sensoreinheit 20 übermittelt ein Messsignal an die Auswerteeinheit 16.

In einem zweiten Verfahrensschritt 66 wird ein Induktivitätsparameter 18 der Steuerspule 14, insbesondere die Induktivität 60 der Steuerspule 14, ermittelt. Der Induktivitätsparameter 18 wird mittels des in der Auswerteeinheit 16 gespeicherten Algorithmus mit Hilfe eines Kalman-Filter Ansatzes und/oder eines reset-observer-Ansatzes ermittelt.

Anschließend wird in einem dritten Verfahrensschritt 68 eine Bestimmung des Schaltzustands der elektromechanischen Schalteinheit 12 mittels des in der Auswerteeinheit 16 gespeicherten Algorithmus mit Hilfe des MEC-Modells und/oder des FEA-Modells durchgeführt. Insbesondere kann eine Aussage darüber getroffen werden, ob ein elektromechanischer Schalter sich in einem geschlossenen oder einem nicht geschlossenen Zustand befindet. Ein Informationssignal wird von der Auswerteeinheit 16 an die Steuereinheit 40 übermittelt. Durch die Steuereinheit 40 wird eine Zufuhr elektrischer Energie an elektrische Verbraucher, beispielsweise an Induktionsspulen eines Induktionskochfelds, gesteuert.

### Bezugszeichen

- 10: Haushaltsgerätevorrichtung
- 12: elektromechanische Schalteinheit
- 14: Steuerspule
- 16: Auswerteeinheit
- 18: Induktivitätsparameter
- 20: Sensoreinheit
- 22: Spulenstrom
- 24: Messwiderstand
- 26: Shunt-Widerstand
- 28: Steuerstromkreis
- 30: Arbeitsstromkreis
- 32: Spulenspannung
- 34: Haushaltsgerät
- 36: Kochzone
- 38: Kochfeld
- 40: Steuereinheit
- 42: Versorgungsquelle
- 44: Relais
- 46: Transistor
- 48: Transistor
- 50: Freilaufdiode
- 52: Schaltelement
- 54: Verbraucher
- 56: Verbraucher
- 58: Spitzenwert
- 60: Induktivität
- 62: Position
- 64: Verfahrensschritt
- 66: Verfahrensschritt
- 68: Verfahrensschritt
- 70: Versorgungsquelle

## Patentansprüche

1. Haushaltsgerät (34) mit zumindest einer Haushaltsgerätevorrichtung (10), insbesondere einer Gargerätevorrichtung, mit zumindest einer elektromechanischen Schalteinheit (12), welche zumindest eine Steuerspule (14) aufweist, **dadurch gekennzeichnet, dass** die Haushaltsgerätevorrichtung (10) zumindest eine Auswerteeinheit (16) aufweist, welche dazu vorgesehen ist, zumindest einen Schaltzustand der elektromechanischen Schalteinheit (12) zu ermitteln, wobei die Auswerteeinheit (16) dazu vorgesehen ist, den Schaltzustand mittels zumindest eines Induktivitätsparameters (18) der Steuerspule (14) zu ermitteln.

2. Haushaltsgerät (34) nach Anspruch 1, **dadurch gekennzeichnet, dass** die Haushaltsgerätevorrichtung (10) zumindest eine Sensoreinheit (20) aufweist, welche zu einer Messung eines Spulenstroms (22) durch die Steuerspule (14) vorgesehen ist.

3. Haushaltsgerät (34) nach Anspruch 2, **dadurch gekennzeichnet, dass** die Sensoreinheit (20) zumindest einen Messwiderstand (24) aufweist.

4. Haushaltsgerät (34) nach Anspruch 3, **dadurch gekennzeichnet, dass** die Haushaltsgerätevorrichtung (10) zumindest einen Steuerstromkreis (28) zur Ansteuerung der Steuerspule (14) aufweist, in welchem der Messwiderstand (24) angeordnet ist.

5. Haushaltsgerät (34) nach einem der Ansprüche 2 bis 4, **dadurch gekennzeichnet, dass** die Auswerteeinheit (16) dazu vorgesehen ist, den Induktivitätsparameter (18) aus einem von der Sensoreinheit (20) bereitgestellten Signal zu bestimmen.

6. Haushaltsgerät (34) nach Anspruch 5, **dadurch gekennzeichnet, dass** die Auswerteeinheit (16) dazu vorgesehen ist, den Induktivitätsparameter (18) aus dem Spulenstrom (22) bei zumindest zeitweise konstanter, an der Steuerspule (14) angelegter Spulenspannung (32) zu bestimmen.

7. Haushaltsgerät (34) nach Anspruch 6, **dadurch gekennzeichnet, dass** die Auswerteeinheit (16) dazu vorgesehen ist, den Induktivitätsparameter (18) als Funktion des Spulenstroms (22) bei zumindest zeitweise konstanter, an der Steuerspule (14) angelegter Spulenspannung (32) zu bestimmen.

8. Haushaltsgerät (34) nach einem der vorhergehenden Ansprüche, **dadurch gekennzeichnet, dass** die Auswerteeinheit (16) dazu vorgesehen ist, den Schaltzustand aus dem Induktivitätsparameter (18) anhand zumindest eines Modells zu bestimmen.

9. Haushaltsgerät (34) nach Anspruch 8, **dadurch gekennzeichnet, dass** die Auswerteeinheit (16) dazu vorgesehen ist, den Schaltzustand aus dem Induktivitätsparameter (18) anhand zumindest eines theoretischen Modells zu bestimmen.

10. Haushaltsgerät (34) nach Anspruch 8 oder 9, **dadurch gekennzeichnet, dass** das Modell ein Magnetic-Equivalent-Circuit-Modell und/oder ein Finite-Element-Analysis-Modell umfasst.

11. Verfahren mit einem Haushaltsgerät (34), insbesondere nach einem der Ansprüche 1 bis 10, mit zumindest einer elektromechanischen Schalteinheit (12), welche zumindest eine Steuerspule (14) aufweist, **dadurch gekennzeichnet, dass** zumindest ein Schaltzustand der elektromechanischen Schalteinheit (12) ermittelt wird, wobei der Schaltzustand mittels zumindest eines Induktivitätsparameters (18) der Steuerspule (14) ermittelt wird.

## Claims

1. Household appliance (34) having at least one household appliance device (10), in particular a cooking appliance device, having at least one electromechanical switching unit (12), which has at least one control coil (14), **characterised in that** the household appliance device (10) has at least one evaluation unit (16), which is provided to determine at least one switching state of the electromechanical switching unit (12), wherein the evaluation unit (16) is provided to determine the switching state by means of at least one inductance parameter (18) of the control coil (14).

2. Household appliance (34) according to claim 1, **characterised in that** the household appliance device (10) has at least one sensor unit (20) which is provided to measure a coil current (22) through the control coil (14).

3. Household appliance (34) according to claim 2, **characterised in that** the sensor unit (20) has at least one measuring resistor (24).

4. Household appliance (34) according to claim 3, **characterised in that** the household appliance device (10) has at least one control current circuit (28) for controlling the control coil (14), in which the measuring resistor (24) is arranged.

5. Household appliance (34) according to one of claims 2 to 4, **characterised in that** the evaluation unit (16) is provided to determine the inductance parameter (18) from a signal provided by the sensor unit (20).

6. Household appliance (34) according to claim 5, **characterised in that** the evaluation unit (16) is provided to determine the inductance parameter (18) from the coil current (22) while the coil voltage (32) is applied at least temporarily constantly to the control coil (14).

7. Household appliance (34) according to claim 6, **characterised in that** the evaluation unit (16) is provided to determine the inductance parameter (18) as a function of the coil current (22) while the coil voltage (32) is applied at least temporarily constantly to the control coil (14).

8. Household appliance (34) according to one of the preceding claims, **characterised in that** the evaluation unit (16) is provided to determine the switching state from the inductance parameter (18) on the basis of at least one model.

9. Household appliance (34) according to claim 8, **characterised in that** the evaluation unit (16) is provided to determine the switching state from the inductance parameter (18) on the basis of at least one theoretical model.

10. Household appliance (34) according to claim 8 or 9, **characterised in that** the model comprises a magnetic equivalent circuit model and/or a finite element analysis model.

11. Method having a household appliance (34), in particular according to one of claims 1 to 10, having at least one electromechanical switching unit (12), which has at least one control coil (14), **characterised in that** at least one switching state of the electromechanical switching unit (12) is determined, wherein the switching state is determined by means of at least one inductance parameter (18) of the control coil (14).

## Revendications

1. Appareil électroménager (34) comprenant au moins un dispositif d'appareil électroménager (10), en particulier un dispositif d'appareil de cuisson, comprenant au moins une unité de commutation électromécanique (12), laquelle comprend au moins une bobine de commande (14),
**caractérisé en ce que** le dispositif d'appareil électroménager (10) comprend au moins une unité d'évaluation (16), qui est configurée pour déterminer au moins un état de commutation de l'unité de commutation électromécanique (12),
dans lequel l'unité d'évaluation (16) est configurée pour déterminer l'état de commutation au moyen d'au moins un paramètre d'inductance (18) de la bobine de commande (14).

2. Appareil électroménager (34) selon la revendication 1, **caractérisé en ce que** le dispositif d'appareil électroménager (10) comprend au moins un élément de capteur (20), qui est configuré pour mesurer un courant de bobine (22) traversant la bobine de commande (14).

3. Appareil électroménager (34) selon la revendication 2, **caractérisé en ce que** l'élément de capteur (20) comprend au moins une résistance de mesure (24).

4. Appareil électroménager (34) selon la revendication 3, **caractérisé en ce que** le dispositif d'appareil électroménager (10) comprend au moins un circuit électrique de commande (28) pour exciter la bobine de commande (14), dans lequel la résistance de mesure (24) est disposée.

5. Appareil électroménager (34) selon l'une des revendications 2 à 4, **caractérisé en ce que** l'unité d'évaluation (16) est configurée pour déterminer le paramètre d'inductance (18) à partir d'un signal délivré par l'élément de capteur (20).

6. Appareil électroménager (34) selon la revendication 5, **caractérisé en ce que** l'unité d'évaluation (16) est configurée pour déterminer le paramètre d'inductance (18) à partir du courant de bobine (22) à une tension de bobine (32) au moins temporairement constante appliquée à la bobine de commande (14).

7. Appareil électroménager (34) selon la revendication 6, **caractérisé en ce que** l'unité d'évaluation (16) est configurée pour déterminer le paramètre d'inductance (18) en fonction du courant de bobine (22) à une tension de bobine (32) au moins temporairement constante appliquée à la bobine de commande (14).

8. Appareil électroménager (34) selon l'une des revendications précédentes, **caractérisé en ce que** l'unité d'évaluation (16) est configurée pour déterminer l'état de commutation à partir du paramètre d'inductance (18) sur la base d'au moins un modèle.

9. Appareil électroménager (34) selon la revendication 8, **caractérisé en ce que** l'unité d'évaluation (16) est configurée pour déterminer l'état de commutation à partir du paramètre d'inductance (18) sur la base d'au moins un modèle théorique.

10. Appareil électroménager (34) selon la revendication 8 ou 9, **caractérisé en ce que** le modèle comprend un modèle de circuit équivalent magnétique et/ou un modèle d'analyse par éléments finis.

11. Procédé utilisant un appareil électroménager (34), en particulier selon l'une des revendications 1 à 10, comprenant au moins une unité de commutation électromécanique (12), laquelle comprend au moins une bobine de commande (14), **caractérisé en ce qu'**au moins un état de commutation de l'unité de commutation électromécanique (12) est déterminé,
dans lequel l'état de commutation est déterminé au moyen d'au moins un paramètre d'inductance (18) de la bobine de commande (14).
